# EUROPÄISCHE PATENTSCHRIFT

(11) **EP 3 071 004 B1**
(45) Veröffentlichungstag und Bekanntmachung des Hinweises auf die Patenterteilung: **14.03.2018**
(21) Anmeldenummer: 16153297.3
(22) Anmeldetag: 29.01.2016
(51) Int. Cl.: H05K 7/14, H05K 7/20

(54) **SCHALTSCHRANKANORDNUNG**
CONTROL CABINET ASSEMBLY
SYSTEME D'ARMOIRE ELECTRIQUE

(30) Priorität: 16.03.2015 DE 202015101339 U
(43) Veröffentlichungstag der Anmeldung: 21.09.2016
(73) Patentinhaber: Rittal GmbH & Co. KG, 35745 Herborn (DE)
(72) Erfinder: Bach, Michael, 35768 Siegbach (DE); Blöcher, Gunther, 35713 Eschenburg (DE); Schmittgall, Volker, 35767 Breitscheid (DE)
(74) Vertreter: Angerhausen, Christoph

(56) Entgegenhaltungen:
- WO-A1-2009/042735
- DE-U1-202013 100 338
- US-A1- 2008 266 789

## Beschreibung

Die Erfindung betrifft eine Schaltschrankanordnung, die einen Schaltschrank mit einem darin aufgenommenen Montagerahmen, der einen Aufnahmeraum für Schaltschrankeinbauten begrenzt, und eine Kühlluftführung aufweist, wobei der Montagerahmen zwei parallel beabstandete Vertikalprofile aufweist, die eine erste Befestigungsebene für die Schaltschrankeinbauten festlegen, und wobei die Kühlluftführung eine Schottung aufweist, die sich zwischen den Vertikalprofilen und einer jeweils zugeordneten Schaltschrankseitenwand erstreckt, wobei die Schottung mindestens einen Durchbruch aufweist, an den mindestens ein Luftzuführkanal, der über den Durchbruch in den Luftzuführkanal eingeleitete Kühlluft in Richtung des Aufnahmeraums leitet, fluidisch angeschlossen ist. Eine derartige Schaltschrankanordnung ist aus der US 2008/266789 A1 bekannt. Ähnliche Anordnungen beschreiben auch die DE 10 2007 034 437 A1 und die WO 2009/042735 A1.

Gattungsgemäße Schaltschrankanordnungen sind häufig darauf ausgelegt, das in einem Bereich zwischen dem Montagerahmen und der Rückwand des Schaltschranks Kaltluft von einem Kühlgerät bereitgestellt wird, die von den Schaltschrankeinbauten, beispielsweise IT-Geräten, wie Servern und dergleichen, rückwärtig angesogen und frontseitig als erwärmte Luft ausgeblasen wird. Es sind jedoch auch IT-Geräte bekannt, die für die seitliche Kühlluftansaugung bzw. -einblasung ausgelegt sind. Um auch für derartige Schaltschrankeinbauten eine ausreichende Kühlluftzufuhr zu gewährleisten ist aus der DE 20 2013 100 338 U1 ein Kanalsystem für die gezielte Kühlluftzufuhr bekannt. Bei diesem ist anstelle von der Schottung oder in diese integriert ein Kühlluftkanal mit bedarfsweise zu öffnenden Durchbrüchen vorgesehen, an die ein Luftzuführkanal angeschlossen werden kann, um die Kühlluft einer bestimmten Schaltschrankkomponente gezielt zuzuführen. Das Kanalsystem hat jedoch den Nachteil, dass es vergleichsweise aufwändig gestaltet ist. Es ist daher die Aufgabe der Erfindung, eine gattungsgemäße Schaltschrankanordnung derart weiterzuentwickeln, dass sie mit möglichst einfachen Mitteln die gezielte Kühlluftzuleitung für Schaltschrankeinbauten mit seitlicher Kühlluftzufuhr ermöglicht.

Diese Aufgabe wird durch eine Schaltschrankanordnung mit den Merkmalen des Anspruchs 1 gelöst. Die abhängigen Ansprüche betreffen jeweils vorteilhafte Ausführungsformen der Erfindung.

Demgemäß ist mindestens eine Versorgungs- oder Datenleitung durch den Luftzuführkanal geführt.

Statt ein Kanalsystem bereitzustellen, schlägt die Erfindung vor, die bei gattungsgemäßen Schaltschrankanordnungen ohnehin vorhandene Schottung zwischen dem Montagerahmen und dem Schaltschrankgehäuse für die Kühlluftzufuhr zu verwenden, indem sie mit Durchbrüchen versehen wird, an die Luftzuführkanäle bedarfsweise angeschlossen werden können.

Es kann vorgesehen sein, dass die Durchbrüche einen Öffnungsquerschnitt aufweisen, der größer als der Einlassquerschnitt des Luftzuführkanals ist. Dabei kann weiterhin vorgesehen sein, dass die Durchbrüche in Bereichen, an denen kein Luftzuführkanal angeschlossen ist, mit einem Verschluss, beispielsweise einem Blindstopfen, verschlossen werden können. Die Schottung kann in Vertikalrichtung eine Mehrzahl Durchbrüche aufweisen, die über Stege voneinander getrennt sind, um der Schottung eine hinreichende Verwindungsfestigkeit zu verleihen.

Der Luftzuführkanal kann darauf ausgelegt sein, die über seine Lufteinlassseite einströmende Kühlluft um im Wesentlichen 90° umzuleiten. Der Luftzuführkanal kann weiterhin als ein Diffusor ausgebildet sein, das heißt, er kann einen größeren Kühlluftauslass als Kühllufteinlass aufweisen. Weiterhin kann vorgesehen sein, dass dem Aufnahmeraum die Kühlluft über einen Kühlluftauslass des Luftzuführkanals seitlich und parallel zur Befestigungsebene zugeführt ist. Der Luftzuführkanal kann eine Umlenkung des über die Durchbrüche ausströmenden Kühlluftstroms um im Wesentlichen 90° bereitstellen.

Die Versorgungs- oder Datenleitung kann von einem in dem Aufnahmeraum aufgenommenen Schaltschrankeinbau durch den Luftzuführkanal und durch den Durchbruch in der Schottung hindurchgeführt sein. Weiterhin kann der Luftzuführkanal einen Durchlass für die Einführung einer Versorgungs- oder Datenleitung in das Innere des Luftzuführkanals aufweisen. Der Durchlass kann dabei an einer von der Schottung abgewandten Vorderseite des Luftzuführkanals ausgebildet sein. Der Luftzuführkanal kann somit auch eine Kabelmanagementfunktion aufweisen, etwa um bei einer Vielzahl an dem Montagerahmen vertikal übereinander angeordneter Schaltschrankeinbauten eine geordnete Kabelführung zu realisieren.

Wie es bereits aus der DE 20 2013 100 338 U1 bekannt ist, kann der Luftzuführkanal in seiner Längsrichtung teleskopierbar ausgeführt sein und dabei zwei Kanalabschnitte aufweisen, die zueinander verschieblich sind. Es kann nunmehr darüber hinaus vorgesehen sein, dass der Luftzuführkanal über den ersten Kanalabschnitt mit dem Durchbruch fluidisch in Verbindung steht, wobei der zweite Kanalabschnitt die Vorderseite mit dem Durchlass für die Kabeldurchfuhr aufweist.

Bei einer Ausführungsform ist der Durchlass in einem Wandabschnitt der Vorderseite des Luftzuführkanals ausgebildet, der unter einem Winkel mit 90° < α < 180°, vorzugsweise unter einem Winkel mit 110° < α < 150° und besonders bevorzugt unter einem Winkel von 135° zu der Längsrichtung (Teleskoprichtung) des Luftzuführkanals angeordnet ist.

Die Schaltschrankanordnung kann einen Schaltschrank mit einem quarderförmigen Rahmengestell aufweisen, dass aus vier Vertikal- und acht Horizontalstreben gebildet ist. Ein derartiges Rahmengestell ist beispielsweise aus der DE 196 47 814 C2 oder aus der DE 296 23 065 U1 bekannt. Dabei kann weiterhin vorgesehen sein, dass die beiden Schaltschrankseitenwände mit dem Rahmengestell verbundene Flachteile sind, wie es aus der DE 198 01 720 C1 bekannt ist. Hierbei kann nunmehr vorgesehen sein, dass sich die Schottung zwischen den Vertikalprofilen des Montagerahmens und dem jeweils zugeordneten Flachteil erstreckt und über ein Dichtelement mit dem Flachteil in Kontakt steht. Die Schottung kann dabei ein Blechteil aufweisen oder aus einem solchen bestehen, das mit einem der Vertikalprofile verbunden, vorzugsweise verschraubt ist, wobei an einer der Schaltschrankseitenwand zugewandten Längskante des Blechteils das Dichtelement aufgesteckt ist. Das Dichtelement kann dabei beispielsweise eine Bürstenleiste sein.

Besonders bevorzugt ist der Montagerahmen ein Montagerahmen für den 19"-Schaltschrankinnenausbau. Für die Montage des Luftzuführkanals kann vorgesehen sein, dass der Montagerahmen angrenzend an die Schottung, oder unter einem festen Abstand zu dieser, eine vertikale Profilseite mit einer in Vertikalrichtung verlaufenden Systemlochung aus regelmäßig beabstandeten Befestigungsaufnahmen aufweist. Grundsätzlich kann der Luftzuführkanal auch direkt mit der Schottung verbunden sein. Für die Befestigung werden vorzugsweise werkzeuglose Befestigungsmittel, wie Klipse oder dergleichen verwendet, um bei Bedarf die vertikale Anordnung des Luftzuführkanals ohne großen Aufwand variieren zu können.

Weitere Einzelheiten der Erfindung werden anhand der nachstehenden Figuren erläutert. Dabei zeigt:
- Figur 1: eine perspektivische Vorderansicht einer Ausführungsform der Schaltschrankanordnung;
- Figur 2: eine Ausschnittsvergrößerung der Figur 1;
- Figur 3: eine perspektivische Rückansicht der Ausführungsform gemäß den Figuren 1 und 2;
- Figur 4: eine Ausschnittsansicht der Figur 3;
- Figur 5: eine perspektivische Ansicht in das Innere eines Luftzuführkanals; und
- Figur 6: eine perspektivische Außenansicht des Luftzuführkanals gemäß Figur 5.

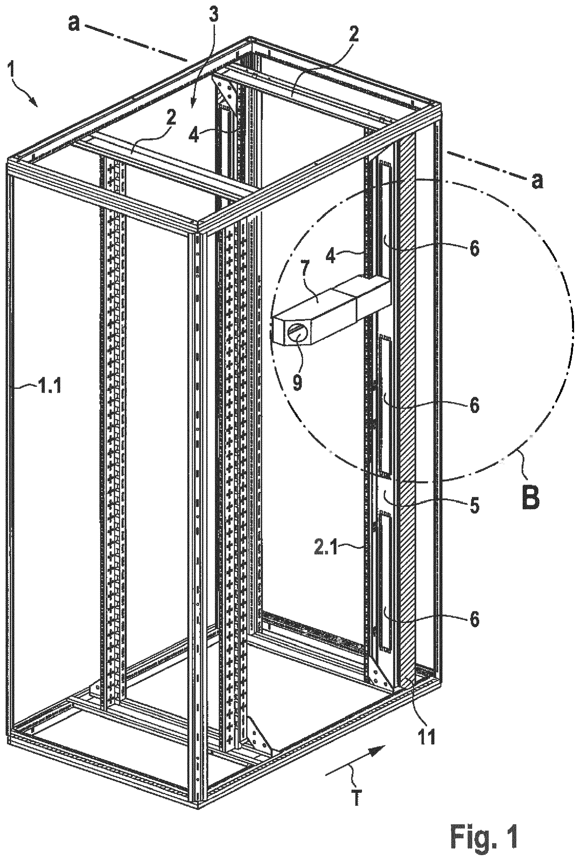

Die Figur 1 zeigt eine Schaltschrankanordnung, die einen Schaltschrank 1 mit einem Rahmengestellt 1.1 aufweist. Zur besseren Veranschaulichung sind die das Rahmengestell 1.1 verkleidenden Flachteile nicht dargestellt. Die in der Darstellung vorderste Seite des Rahmengestells 1.1 bildet die Türseite, während die gegenüberliegende Seite die Rückseite des Schaltschranks 1 bildet. Dementsprechend ist in Figur 1 die Tiefenrichtung T angegeben.

In dem von dem Rahmengestell 1.1 gebildeten Schaltschrankinnenraum sind ein erster und ein zweiter Montagerahmen 2 aufgenommen, die jeweils eine 19"- Montageebene für 19"-Schaltschrankeinbauten, wie Server und derselben bilden. Die Montagerahmen 2 weisen jeweils zwei parallel beabstandete Vertikalprofile 4 auf, die endseitig über Horizontalschienen miteinander verbunden sind, welche dann wiederum mit den Horizontalprofilen des Rahmengestells 1.1 verbunden sind, um die Montagerahmen 2 im Innenraum des Schaltschranks 1 und unter einem bestimmten Rasterabstand in Tiefenrichtung, der durch die Systemlochung der Horizontalprofile des Rahmengestells 1.1. vorgegeben ist, anzuordnen.

Der in der Darstellung hintere Montagerahmen 2 weist eine Schottung 5 auf, die sich von einem der Vertikalprofile 4 in Richtung der Seitenwand des Schaltschranks 1 erstreckt, um so den Aufnahmeraum 3 für die Schaltschrankeinbauten von einem Bereich, der hinter dem hinteren Montagerahmen 2 und der Rückwand des Schaltschranks 1 gebildet ist und in den Kühlluft eingeblasen werden kann, abzuschotten. Die Schottung 5 kann eine auf ihrer der Schaltschrankseitenwand zugewandten Längskante eine Bürstenleiste 11 aufweisen, die als Dichtelement dient.

Die Schottung 5 weist vertikal voneinander beabstandet eine Mehrzahl Durchbrüche 6 auf, die über Stege voneinander getrennt sind, um so der beispielsweise als Blechteil ausgebildeten Schottung 5 eine ausreichende Stabilität zu verleihen. Der dargestellte Luftzuführkanal 7 ist über seine Lufteinlassseite mit einem der Durchbrüche 6 fluidisch verbunden. An seiner der Lufteinlassseite gegenüberliegenden Vorderseite weist der Luftzuführkanal 7 einen Durchlass 9 für die Einführung von Versorgungs- oder Datenleitungen auf.

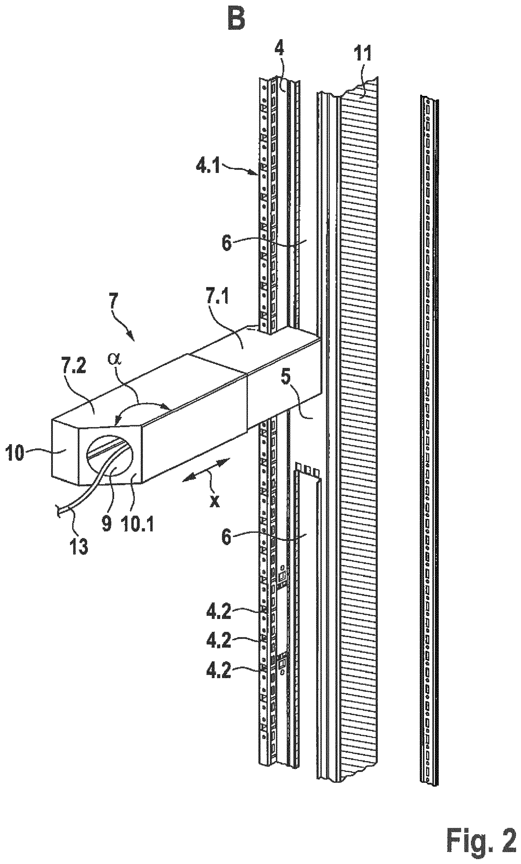

Die Montage des Luftzuführkanals 7 an dem Vertikalprofil 4 des Montagerahmens 2 sowie die Zuführung der Versorgungs- oder Datenleitungen ist genauer in Figur 2 gezeigt. Hier ist erkennbar, dass die Versorgungs- oder Datenleitung 13 über den an der Vorderseite 10 des Luftzuführkanals 7 ausgebildeten Durchlass 9 in das Innere des Luftzuführkanals 7 eingeleitet ist. Genauer weist die Vorderseite 10 einen Wandabschnitt 10.1 auf, in welchem der Durchlass 9 ausgebildet ist, wobei der Wandabschnitt 10.1 um einen Winkel α von ungefähr 135° zu der Längsrichtung x des Luftzuführkanals 7 ausgerichtet ist, um die Kabeleinführung zu vereinfachen. Die Figur 2 zeigt weiterhin das Vertikalprofil 4 des hinteren Montagerahmens 2 gemäß Figur 1, welches eine entlang seiner Vertikalrichtung ausgebildete Systemlochung aus kreisrunden Durchlässen und rechteckigen Durchlässen aufweist. Der Luftzuführkanal 7 kann beispielsweise über Klipse mit dem Vertikalprofil 4 verbunden sein. Es kann auch vorgesehen sein, dass Käfigmuttern in das Vertikalprofil 4 eingesetzt sind, die für eine Verschraubung des Luftzuführkanals 7 mit dem Vertikalprofil 4 dienen.

Es ist weiterhin in Figur 2 zu erkennen, dass der Luftzuführkanal 7 den Öffnungsquerschnitt des Durchbruchs 6 der Schottung 5 nicht vollständig überdeckt. Es kann vorgesehen sein, dass bedarfsweise in den von dem darstellten Luftzuführkanals 7 nicht bedeckten Öffnungsquerschnitten des Durchbruchs 6 weitere Luftzuführkanäle 7 angeordnet sind, um in Vertikalrichtung höher oder tiefer gelegenen Schaltschrankeinbauten Kühlluft zuzuführen. Es kann aber auch vorgesehen sein, dass die nicht von einem Luftzuführkanal 7 bedeckten Öffnungsquerschnitte der Durchbrüche 6 von einem Blindstopfen oder einer wahlweise in die Durchbrüche 6 einrastbaren Abdeckung verschlossen sind.

Die Schottung 5 kann als ein Blechformteil oder aus Spritzgusskunststoff gefertigt sein. Entlang der von dem Vertikalprofil 4 abgewandten Längskante der Schottung 5 ist ein Dichtelement 11 aufgesteckt, welches beispielsweise eine Bürstenleiste sein kann, um die Schottung 5 gegenüber einer (nicht dargestellten) Seitenwand des Schaltschranks 1 abzudichten.

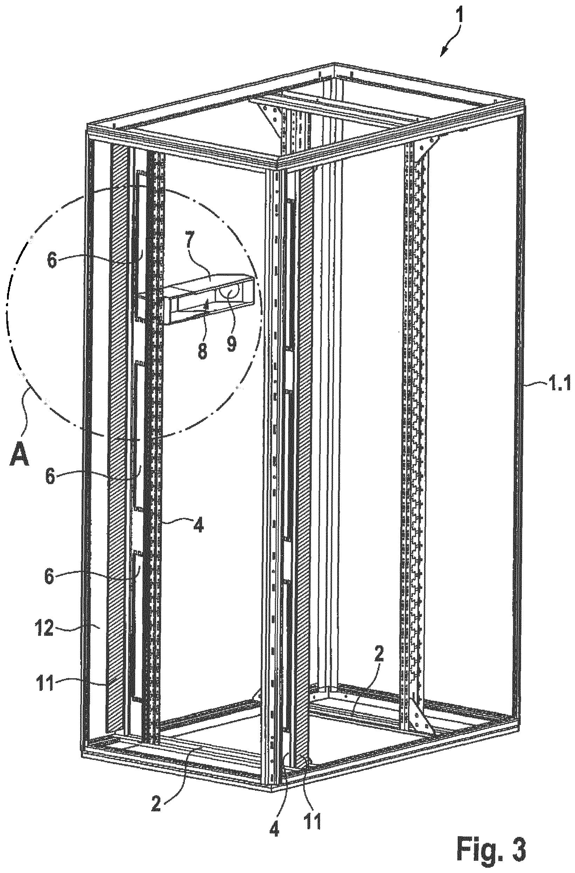

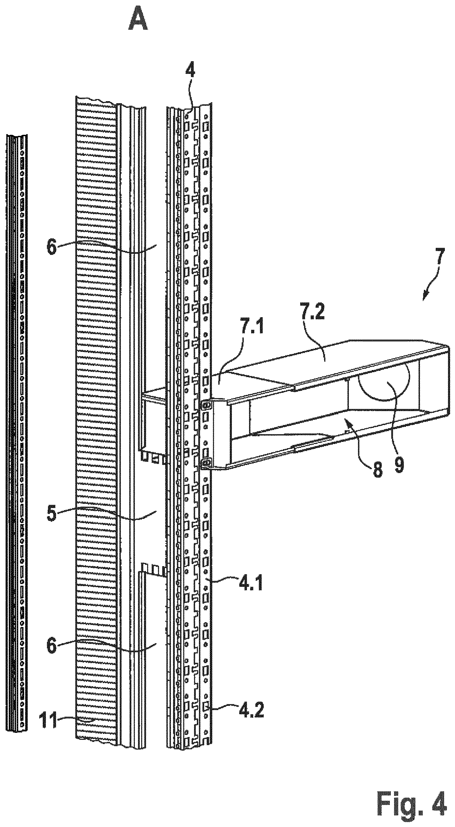

Die Figuren 3 und 4 zeigen die Schaltschrankanordnung gemäß Figur 1 und 2 in der Rückansicht. In Figur 3 ist zu erkennen, dass über die an den gegenüberliegenden Vertikalprofilen 4 ausgebildeten Dichtelemente 11 ein Bereich zwischen der Rückwand und dem hinteren Montagerahmen 2 abgeschottet ist, welcher beispielsweise für die Kühllufteinblasung über ein Kühlgerät dient, so dass die von dem Kühlgerät bereitgestellte Kühlluft gezielt über die Durchbrüche 6 und die Luftzuführkanäle 7 den Schaltschrankeinbauten bereitgestellt werden kann. Im Anwendungsfall sind zwischen den Vertikalprofilen 4 des Montagerahmens die Schaltschrankeinbauten angeordnet. Soweit nicht die vollständige Bauhöhe des Montagerahmens mit Einbauten bestückt ist, können die freibleibenden Bereiche mit Blindabdeckungen verschlossen sein, um einen unerwünschten Kühlluftdruckverlust zu vermeiden.

Die Figur 4 zeigt, dass das Vertikalprofil 4 des Montagerahmens 2 angrenzend an die Schottung 5 eine vertikale Profilseite 4.1 mit einer in Vertikalrichtung verlaufenden Systemlochung 4.2 aus regelmäßig beabstandeten Befestigungsaufnahmen für die Montage des Luftzuführkanals 7 aufweist. Wie in der Zusammenschau der Figuren 3 und 4 zu erkennen ist, ist die vertikale Profilseite 4.1 eine von drei Seitenwänden eines Profilvorsprungs des Vertikalprofils 4, von denen zwei über eine dritte Profilseite parallel voneinander beabstandet verbunden sind. Der Profilvorsprung greift bei montiertem Luftzuführkanal 7 in eine Ausnhemung 14 an der Lufteinlassseite des ersten Kanalabschnitts 7.1 des Luftzuführkanals 7 ein, wodurch eine Vorpositionierung des Luftzuführkanals 7 erreicht wird. Über diesen Profilvorsprung ist der Luftzuführkanal 7 lediglich noch vertikal verschieblich, dass heißt, verschieblich entlang der Durchbrüche 6, so dass der Luftzuführkanal 7, wenn er auf den Profilvorsprung aufgesetzt ist, über die Systemlochung in dem Vorsprung an einer gewünschten Position festgelegt werden kann.

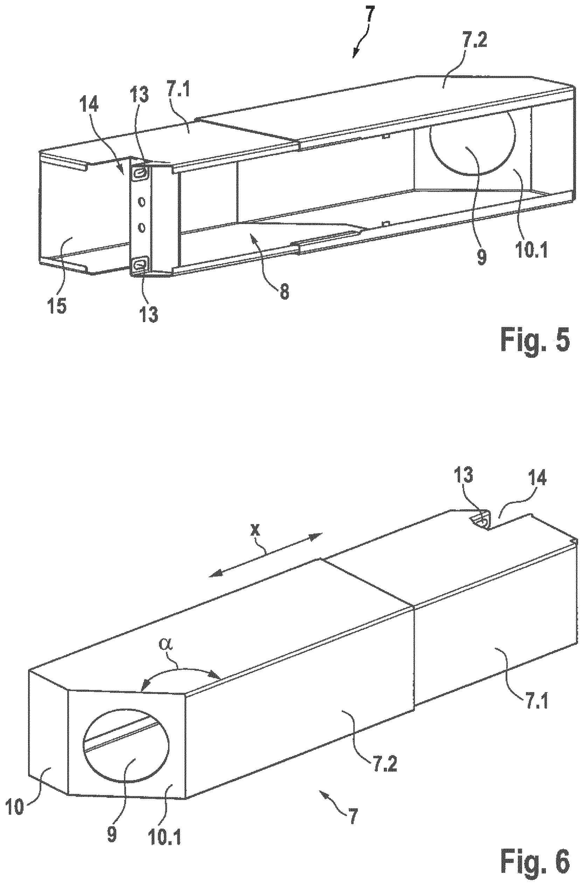

Wie in den Figuren 5 und 6 zu erkennen ist, ist der Luftzuführkanal 7 aus einem ersten und einem zweiten Kanalabschnitt 7.1, 7.2 zusammengesetzt, die in Längsrichtung x des Luftzuführkanals zueinander verschieblich sind, um so den Luftauslassquerschnitt 8 entsprechend dem vorgefundenen Lufteinlassquerschnitt der betreffenden Schaltschrankeinbauten anzupassen. Der zweite Kanalabschnitt 7.2 weist in einem angewinkelten Wandabschnitt 10.1 an der Vorderseite 10 einen Durchlass 9 auf, über den eine Versorgungs- oder Datenleitung 13 (siehe Figur 2) in das Innere des Luftzuführkanals eingeleitet werden kann. Der Luftzuführkanal 7 weist einen Einlassquerschnitt 15 auf, über den Kühlluft in den Luftzuführkanal 7 eingeleitet wird. Der Auslassquerschnitt 8 des Luftzuführkanals 7 ist größer als der Lufteinlassquerschnitt 15 ausgebildet, so dass der Luftzuführkanal weiterhin die Funktion eines Diffusors aufweist. Angrenzend an den Lufteinlassquerschnitt 15 ist die Ausnehmung 14 ausgebildet, über die der Luftzuführkanal 7 auf ein Vertikalprofil 4 eines Montagerahmens 2 aufgeschoben werden kann (vgl. Figuren 2 und 4). Der Ausnehmung 14 beigeordnet sind Befestigungsaufnahmen 13, die in die Ausnehmung 14 münden, so dass über diese der Luftzuführkanal 7 an dem in die Ausnehmung 14 eingeschobenen Profilvorsprung festgelegt, beispielsweise verschraubt werden kann.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. Schaltschrankanordnung, die einen Schaltschrank (1) mit einem darin aufgenommenen Montagerahmen (2), der einen Aufnahmeraum (3) für Schaltschrankeinbauten begrenzt, und eine Kühlluftführung (5, 6, 7) aufweist, wobei der Montagerahmen (2) zwei parallel beabstandete Vertikalprofile (4) aufweist, die eine erste Befestigungsebene (a) für die Schaltschrankeinbauten festlegen, und wobei die Kühlluftführung (5, 6, 7) eine Schottung (5) aufweist, die sich zwischen den Vertikalprofilen (4) und einer jeweils zugeordneten Schaltschrankseitenwand (12) erstreckt, wobei die Schottung (5) mindestens einen Durchbruch (6) aufweist, an den mindestens ein Luftzuführkanal (7), der über den Durchbruch (6) in den Luftzuführkanal (7) eingeleitete Kühlluft in Richtung des Aufnahmeraums (3) leitet, fluidisch angeschlossen ist, **dadurch gekennzeichnet, dass** mindestens eine Versorgungs- oder Datenleitung (13) durch den Luftzuführkanal (7) geführt ist.

2. Schaltschrankanordnung nach Anspruch 1, bei der dem Aufnahmeraum (3) die Kühlluft über einen Kühlluftauslass (8) des Luftzuführkanals (7) seitlich und parallel zur Befestigungsebene (a) zugeführt ist.

3. Schaltschrankanordnung nach Anspruch 1, bei der die Versorgungs- oder Datenleitung (13) von einem in dem Aufnahmeraum (3) aufgenommenen Schaltschrankeinbau durch den Luflzuführkanal (7) und durch den Durchbruch (6) in der Schottung (5) hindurch geführt ist.

4. Schaltschrankanordnung nach Anspruch 1, bei der der Luftzuführkanal (7) einen Durchlass (9) für die Einführung der Versorgungs- oder Datenleitung (13) in das Innere des Luftzuführkanals (7) aufweist.

5. Schaltschrankanordnung nach Anspruch 4, bei der der Durchlass (9) an einer von der Schottung (5) abgewandten Vorderseite (10) des Luftzuführkanals (7) ausgebildet ist.

6. Schaltschrankanordnung nach Anspruch 5, bei der der Luftzuführkanal (7) in seiner Längsrichtung (x) teleskopierbar ausgeführt ist, mit einem ersten Kanalabschnitt (7.1), über den der Luftzuführkanal (7) mit dem Durchbruch (6) fluidisch in Verbindung steht, und mit einem zweiten Kanalabschnitt (7.2), der die Vorderseite (10) mit dem Durchlass (9) aufweist.

7. Schaltschrankanordnung nach einem der Ansprüche 4 bis 6, bei der der Durchlass (9) in einem Wandabschnitt (10.1) der Vorderseite (10) des Luftzuführkanals (7) ausgebildet ist, der unter einem Winkel (α) mit 90° < α < 180°, vorzugsweise unter einem Winkel (α) mit 110° < α < 150°, und besonders bevorzugt unter einem Winkel (α) von 135° zu der Längsrichtung (x) angeordnet ist.

8. Schaltschrankanordnung nach einem der vorangegangenen Ansprüche, bei der der Schaltschrank ein quaderförmiges Rahmengestell (1.1) aufweist, das aus vier Vertikal- und acht Horizontalstreben gebildet ist, wobei die beiden Schaltschrankseitenwände (12) mit dem Rahmengestell (1.1) verbundene Flachteile sind, und wobei sich die Schottung (5) zwischen den Vertikalprofilen (4) des Montagerahmens (2) und dem jeweils zugeordneten Flachteil erstreckt und über ein Dichtelement (11) mit dem Flachteil in Kontakt steht.

9. Schaltschrankanordnung nach Anspruch 8, bei der die Schottung (5) ein Blechteil aufweist, das mit einem der Vertikalprofile (4) verbunden, vorzugsweise verschraubt ist, wobei an einer der Schaltschrankseitenwand (12) zugewandten Längskante des Blechteils das Dichtelement (11) aufgesteckt ist.

10. Schaltschrankanordnung nach Anspruch 8 oder 9, bei der das Dichtelement (11) eine Bürstenleiste ist.

11. Schaltschrankanordnung nach einem der vorangegangenen Ansprüche, bei der der Montagerahmen (2) ein Montagerahmen für den 19"-Schaltschrankinnenausbau ist.

12. Schaltschrankanordnung nach einem der vorangegangenen Ansprüche, bei der das Vertikalprofil (4) des Montagerahmens (2) angrenzend an die Schottung (5), oder unter einem festen Abstand zu dieser, eine vertikale Profilseite (4.1) mit einer in Vertikalrichtung verlaufenden Systemlochung (4.2) aus regelmäßig beabstandeten Befestigungsaufnahmen für die Montage des mindestens einen Luftzuführkanals (7) aufweist.

## Claims

1. Switch cabinet arrangement which comprises a switch cabinet (1) with an installation frame (2) accommodated therein, which delimits an accommodation space (3) for switch cabinet fixtures and which comprises a cooling air duct (5, 6, 7), wherein the installation frame (2) comprises two parallel separated vertical profiles (4) which establish a first attachment plane (a) for the switch cabinet fixtures and wherein the cooling air duct (5, 6, 7) comprises a partition (5) which extends between the vertical profiles (4) and a respective associated switch cabinet side wall (12), wherein the partition (5) comprises at least one perforation (6) to which at least one air supply channel (7) is fluidically connected, which leads cooling air introduced via the perforation (6) into the air supply channel (7) in the direction of the accommodation space (3), **characterized in that** at least one supply or data line (13) is led through the air supply channel (7).

2. Switch cabinet arrangement according to Claim 1, in which the cooling air is supplied to the accommodation space (3) via a cooling air outlet (8) of the air supply channel (7) to the side and parallel relative to the attachment plane (a).

3. Switch cabinet arrangement according to Claim 1, in which the supply or data line (13) is led from a switch cabinet fixture accommodated in the accommodation space (3), through the air supply channel (7) and through the perforation (6) in the partition (5).

4. Switch cabinet arrangement according to Claim 1, in which the air supply channel (7) comprises a passage (9) for the introduction of the supply or data line (13) into the interior of the air supply channel (7).

5. Switch cabinet arrangement according to Claim 4, in which the passage (9) is formed on a front side (10) of the air supply channel (7) facing away from the partition (5).

6. Switch cabinet arrangement according to Claim 5, in which the air supply channel (7) is designed so it can be telescoped in its longitudinal direction (x), with a first channel section (7.1) through which the air supply channel (7) is fluidically connected to the perforation (6), and with a second channel section (7.2) which has the front side (10) with the passage (9).

7. Switch cabinet arrangement according to any one of Claims 4 to 6, in which the passage (9) is formed in a wall section (10.1) of the front side (10) of the air supply channel (7), which is arranged at an angle (α) where 90° < α < 180°, preferably at an angle (α) where 110° < α < 150°, and particularly preferably at an angle (α) of 135° relative to the longitudinal direction (x).

8. Switch cabinet arrangement according to any one of the preceding claims, in which the switch cabinet has a cuboid rack (1.1) which is formed from four vertical and eight horizontal struts, wherein the two switch cabinet side walls (12) are flat parts connected to the rack (1.1), and wherein the partition (5) extends between the vertical profiles (4) of the installation frame (2) and the respective associated flat part and is in contact with the flat part via a sealing element (11).

9. Switch cabinet arrangement according to Claim 8, in which the partition (5) has a sheet metal part which is connected to one of the vertical profiles (4), preferably by screw connection, wherein the sealing element (11) is put on a longitudinal edge of the sheet metal part facing the switch cabinet side wall (12).

10. Switch cabinet arrangement according to Claim 8 or 9, in which the sealing element (11) is a brush strip.

11. Switch cabinet arrangement according to any one of the preceding claims, in which the installation frame (2) is an installation frame for the 19" switch cabinet interior construction.

12. Switch cabinet arrangement according to any one of the preceding claims, in which the vertical profile (4) of the installation frame (2) has, adjoining the partition (5), or at a fixed distance therefrom, a vertical profile side (4.1) with a system perforation (4.2) extending in vertical direction and consisting of regularly spaced attachment accommodations for the installation of the at least one air supply channel (7).

## Revendications

1. Disposition d'armoire de commande qui comprend une armoire de commande (1) avec un châssis de montage (2) logé à l'intérieur, qui comprend un espace de logement (3) pour des aménagements d'armoire de commande et un guidage d'air de refroidissement (5, 6, 7), le châssis de montage (2) comprenant deux profilés verticaux (4) parallèles, qui définissent un premier plan de fixation (a) pour les aménagements d'armoire et le guidage d'air de refroidissement (5, 6, 7) comprenant une cloison (5), qui s'étend entre les profilés verticaux (4) et une paroi latérale d'armoire de commande (12) correspondante, la cloison (5) comprenant au moins un perçage (6), au niveau duquel au moins un canal d'alimentation en air (7), qui conduit l'air de refroidissement introduit par le perçage (6) dans le canal d'alimentation en air (7) en direction de l'espace de logement (3), est raccordé de manière fluidique, **caractérisée en ce qu'**au moins une conduite d'alimentation ou de données (13) est guidée à travers le canal d'alimentation en air (7).

2. Disposition d'armoire de commande selon la revendication 1, dans laquelle l'air de refroidissement est introduit dans l'espace de logement (3) par l'intermédiaire d'une sortie d'air de refroidissement (8) du canal d'alimentation en air (7) sur le côté et parallèlement au plan de fixation (a).

3. Disposition d'armoire de commande selon la revendication 1, dans laquelle la conduite d'alimentation ou de données (13) est guidée par un aménagement logé dans l'espace de logement (3) à travers le canal d'alimentation en air (7) et à travers le perçage (6) dans la cloison (5).

4. Disposition d'armoire de commande selon la revendication 1, dans laquelle le canal d'alimentation en air (7) comprend un passage (9) pour l'introduction de la conduite d'alimentation ou de données (13) à l'intérieur du canal d'alimentation en air (7).

5. Disposition d'armoire de commande selon la revendication 4, dans laquelle le passage (9) est réalisé au niveau d'un côté avant (10) du canal d'alimentation en air (7) opposé à la cloison (5).

6. Disposition d'armoire de commande selon la revendication 5, dans laquelle le canal d'alimentation en air (7) est réalisé de manière télescopique dans sa direction longitudinale (x), avec une première portion de canal (7.1), par l'intermédiaire de laquelle le canal d'alimentation en air (7) est relié de manière fluidique avec le perçage (6) et avec une deuxième portion de canal (7.2), qui comprend le côté avant (10) avec le passage (9).

7. Disposition d'armoire de commande selon l'une des revendications 4 à 6, dans laquelle le passage (9) est réalisé dans une portion de paroi (10.1) du côté avant (10) du canal d'alimentation en air (7), qui est disposé avec un angle (α) 90° < α < 180°, de préférence avec un angle (α) 110° < α < 150° et plus particulièrement de préférence avec un angle (α) de 135° par rapport à la direction longitudinale (x).

8. Disposition d'armoire de commande selon l'une des revendications précédentes, dans laquelle l'armoire de commande comprend un châssis parallélépipédique (1.1) qui est constitué de quatre entretoises verticales et de huit entretoises horizontales, les deux parois latérales de l'armoire de commande (12) étant des pièces plates reliées par le châssis (1.1) et la cloison (5) s'étendant entre les profilés verticaux (4) du châssis de montage (2) et la pièce plate correspondante et étant en contact avec la pièce plate par l'intermédiaire d'un élément d'étanchéité (11).

9. Disposition d'armoire de commande selon la revendication 8, dans laquelle la cloison (5) comprend une pièce en tôle, qui est reliée avec un des profilés verticaux (4), de préférence vissée, l'élément d'étanchéité (11) étant enfiché sur une arête longitudinale de la pièce en tôle orientée vers la paroi latérale de l'armoire de commande (12).

10. Disposition d'armoire de commande selon la revendication 8 ou 9, dans laquelle l'élément d'étanchéité (11) est un joint balai.

11. Disposition d'armoire de commande selon l'une des revendications précédentes, dans laquelle le châssis de montage (2) est un châssis de montage pour l'extension intérieure d'armoire de commande de 19".

12. Disposition d'armoire de commande selon l'une des revendications précédentes, dans laquelle le profilé vertical (4) du châssis de montage (2) comprend, à proximité de la cloison (5), ou à une distance fixe de celle-ci, un côté profilé vertical (4.1) avec un système de perforation (4.2) s'étendant dans la direction verticale, constitué de logements de fixation disposés à intervalles réguliers pour le montage de l'au moins un canal d'alimentation en air (7).
